# EUROPEAN PATENT APPLICATION

(11) **EP 0 577 385 A1**
(43) Date of publication of application: **05.01.1994**
(21) Application number: 93305070.0
(22) Date of filing: 29.06.1993
(51) Int. Cl.: G03F 7/11

(54) **Photocurable elements and slip film compositions used therein**

(30) Priority: 29.06.1992 US 906154
(71) Applicant: PT Sub, Inc., Wilmington, Delaware 19805 (US)
(72) Inventor: Williams, Trevor J., Mableton, Georgia 30059 (US)
(74) Representative: Bentham, Stephen

(57) **Abstract**

The invention relates to relates to photocurable elements and processes for making printing reliefs therefrom. In particular, the present invention relates to new aqueous-processible photocurable elements comprising an aqueous-processible slip film laminated to a photocurable layer. The slip film is resistant to aging, eliminates surface tack, and does not delaminate from the photocurable layer during removal of the cover sheet of the element. The slip film comprises an aqueous-processible polymeric binder and a non-migrating surfactant in an amount effective to ensure preferential adherence of the slip film to the photocurable composition, relative to the cover sheet.

## Description

The present invention relates to photocurable elements and processes for making printing reliefs therefrom. In particular, the present invention relates to new aqueous solvent-developable photocurable elements comprising an aqueous-processible slip film which is resistant to aging, eliminates surface tack, and does not delaminate from the photocurable element during removal of the cover sheet.

Photocurable elements generally comprise a backing or support sheet on which is coated at least one layer of photocurable composition. A cover sheet is superimposed on the surface of the uppermost photocurable layer, opposite the support sheet, and protects the photocurable composition during storage, shipment and handling. In preparing a relief printing plate from the element, the cover sheet is stripped off the element and an image-bearing transparency is laid over the photocurable composition. Thereafter the photocurable element is exposed to actinic radiation through the image-bearing transparency and areas of photocurable composition that are exposed to the radiation passing through the image-bearing transparency are cured through photochemical reactions. The unexposed photocurable composition remains uncured, and is later removed by washing with a developing solvent and physical action, e.g., brushing. After washing, the element is subjected to post-development treatment such as drying and detackifying.

Because of the tackiness of most uncured photocurable compositions used in these elements, contacting the image-bearing transparency with the photocurable layer will cause the transparency to adhere to it. This makes removing or repositioning the transparency difficult; further, removing the transparency after exposure could damage the photocurable layer (and the transparency) should any amount of photocurable material stick tenaciously to the transparency.

Slip films prevent this problem by providing a non-tacky, radiation-transparent barrier between the image-bearing transparency and the photocurable element. A good slip film will adhere well to the photocurable composition and be easily removed after exposure, preferably when washing the element to remove the uncured photocurable composition. At the same time, the slip film should be just tacky enough on its surface interfacing the cover sheet to adhere to, and prevent premature delamination of, the cover sheet, but still release from the cover sheet when it is stripped off. The slip film should also allow repositioning of the image-bearing transparency, if necessary, before exposure, and flex with the photocurable element so it does not craze (crazing affects radiation transmission through the slip film). It has been difficult to find a slip film having the necessary balance of all these qualities.

In photocurable elements which are meant to be developed with aqueous-based developers, the developer must also remove the slip film. Slip films have been made of various water-soluble or dispersible compositions, e.g. carboxymethyl cellulose, polyvinyl alcohol, dextrine, and cellulose ether. However, slip films made of these compositions having the ideal characteristics described in the previous paragraph have not easily been obtained. Thus, there remains a need for an aqueous-processible slip film for photocurable elements having the advantages described above.

The present invention is directed towards aqueous-processible compositions which can be used as slip films for photocurable elements. The slip films have the advantage of preferentially adhering to a flexographic photocurable composition relative to a cover sheet which is laminated to the slip film. The compositions of the invention comprise (1) a polymeric binder, and (2) a non-migrating surfactant.

The invention is further directed towards aqueous-processible photocurable elements comprising, in order, (a) a support sheet; (b) at least one layer of an aqueous-processible photocurable composition; (c) an aqueous-processible slip film; and (d) a flexible cover sheet, wherein the slip film comprises (1) a polymeric binder, and (2) a non-migrating surfactant in an amount which provides preferential adherence of the slip film to the photocurable composition, relative to the cover sheet.

The present invention is also further directed towards a process for making a flexographic printing relief from a photocurable element, comprising the steps of: (I) imagewise exposing to actinic radiation an aqueous-processible photocurable element comprising, in order: (a) a support sheet; (b) at least one layer of an aqueous-processible photocurable composition; (c) an aqueous-processible slip film, and (d) a flexible cover sheet, wherein the slip film comprises (1) a polymeric binder, and (2) a non-migrating surfactant in an amount which provides preferential adherence of the slip film to the photocurable composition, relative to the cover sheet; and (II) removing the unexposed portions of the photocurable composition by washing the element with an aqueous or semi-aqueous solvent.

Figure 1 depicts, in cross-section, a photocurable element of the invention.

Figures 2,3, and 4 depict a flexographic printing plate being prepared from a photocurable element of the invention.

Figure 5 depicts, in cross-section, a process for exposing a liquid photocurable element using a thin polyester cover sheet having coated onto it a slip film of the invention.

According to this invention, it has been found that non-migrating surfactants can be used in aqueous-processible slip films to provide improved processing characteristics. The slip films thus are more readily soluble or dispersible in aqueous developing solvents. It has also been found that such surfactants can be used to modify the adhesiveness of the slip films, such that in photocurable elements the slip film can be made preferentially adherent to the photocurable layer, relative to the cover sheet, while maintaining sufficient adhesion to the cover sheet to prevent unwanted delamination and maintain the integral structure of the element. This result was unexpected and is especially beneficial since aqueous-processible photocurable materials often have poor adhesion to conventional slip film materials.

The inventor has also found that the desired preferential adhesion may be attained in slip films containing mobile surfactants, but that the preferential adhesion is lost over time. The slip film thus reverts to the adhesiveness of the polymeric binder, which, in most cases, preferentially adheres to the cover sheet. Thus, stripping of the cover sheet prior to exposure also removes the slip film. These problems are avoided through the use of the non-migrating surfactants of the invention, which have been found not only to provide desired processibility and preferential adhesion, but also to prevent any diminution of these properties, at least during normal periods of storage.

The aqueous or semi-aqueous-processible slip film of the invention comprises a non-migrating surfactant distributed substantially uniformly throughout an aqueous-processible polymeric binder. The term "surfactant" is used herein in its usual sense, and thus denotes any surface active substance which reduces the surface tension of water. By "non-migrating surfactant" is meant any surfactant that is substantially immobile in a solid matrix of the polymeric binder. As a result, the surfactant is unable to diffuse or migrate out of the polymeric binder matrix, and thus will not migrate from the slip film layer to adjacent layers, such as the photocurable layer of the photocurable element. Such surfactants are preferably solid at room temperature, and are present in a solid form in the formed slip film. Other kinds of surfactants, particularly those in liquid form, will migrate from the slip film to the photocurable layer; for instance, as the plate sits in storage in the warehouse or in the print shop. In a slip film containing such migrating surfactants, this results in the slip film preferentially sticking to the cover sheet, resulting in its removal from the photocurable composition when the cover sheet is stripped off. Such slip films may also delaminate from the photocurable layer.

"Aqueous-processible" as used herein refers to the capability or property of being dissolvable or dispersible in water or a substantially water-based solvent system. "Substantially water-based" means that at least about 40% by weight of the solvent system is water, with the remainder of the system being other solvent(s) used in processing slip film materials, preferably alcohols or other non-halogenated solvents, or additives, e.g., which promote the removal of the slip film and the uncured photocurable composition. Thus, aqueous-processible slip film and photocurable compositions are those which can be removed from a photocurable element by washing with water or a substantially water-based solvent system.

Preferred non-migrating surfactants have a hydrophilic-lipophilic balance (HLB) of about 16 to 19. Examples of these preferred non-migrating surfactants are alkylphenol-polyethoxylated alcohols having the generic formula R₁-B-OA₁O(A₂O)ᵣH, wherein R₁ is a linear or branched alkyl group containing from 6 to 18 carbon atoms, B is a C₆ to C₁₀ arylene group, A₁ and A₂ are each individually a C₁ to C₅ alkylene group, and r is of a magnitude sufficient to make the surfactant solid at room temperature, i.e., below about 30^{º} C, and more preferably is solid at temperatures below about 60^{º} C. Preferably r is greater than about 70 and more preferably greater than about 90. A particularly preferred non-migrating surfactant is one of the above formula wherein R₁ is a nonyl or octyl group, and B is phenylene. Other exemplary non-migrating surfactants of the above formula are those sold under the tradenames TERGITOL NP40 (Union Carbide); IGEPAL CO990; IGEPAL CA950; IGEPAL CO880 (GAF Corporation); and, preferably, T-DET 100 (Thompson-Hayward Chemical Corporation) In the latter compound A₁ and A₂ are methylene groups, R₁ is a nonyl group, B is phenylene, and r is about 100.

The ratio of non-migrating surfactant to polymeric binder in the slip film is important to ensuring the proper adhesion relationship. If too little non-migrating surfactant is present in a slip film of the invention, the cover sheet will stick too well to the slip film; too much surfactant, and the cover sheet will either not adhere to, or delaminate in storage from, the slip film. The correct proportion of non-migrating surfactant will ensure that there will be just enough tack to cause the cover sheet to remain in place on the photocurable element before use. While the precise ratio of non-migrating surfactant to polymeric binder will depend on the particular binder and photocurable composition used in the element, a generally preferred weight ratio range of surfactant to polymeric binder is about 1:35 to 1:66, and more preferably about 1:40 to 1:60.

The polymeric binder used in the slip film may be any one which has the desired adhesiveness, flexibility, and processibility in water-based solvents as herein described. Such binders include carboxyalkylcelluloses such as carboxymethylcellulose, hydroxyalkylcelluloses such as 2-hydroxypropylcellulose, alkylcelluloses such as methylcelluloses and ethylcelluloses, polyvinylalcohols, polyacrylic acids, polyethylene oxides, polyvinylmethyl ethers, and the synthetic sucrose product sold under the registered trademark FICOLL. The polymeric release composition described in U.S. Patent No. 5,077,175, issued December 31, 1991 to Fryd et al.,
may also be used in the slip film. That release composition comprises at least 60% of a substantially hydrolyzed polyvinyl alcohol and at least 8% plasticizer (all percentages being based on the total weight of release composition). The binder may also be a mixture of any or all of the aforementioned compounds.

Preferred binders for use in the slip film are hydroxyalkylcelluloses having repeating units of the general formula 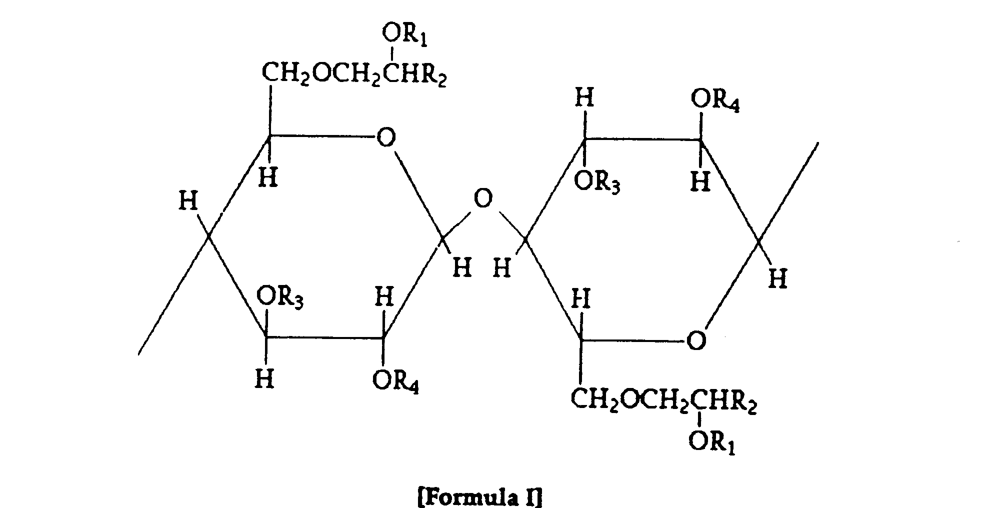
wherein
R₁ is H or 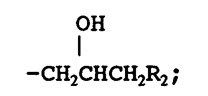
R₂ is H or a C₁ to C₃ alkyl group; and
R₃ and R₄ are each independently H or 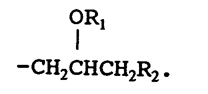
Particularly preferred are those hydroxyalkylcelluloses produced by derivatization of cellulose with propylene or ethylene oxide (with propylene oxide more particularly preferred), at elevated temperatures and pressures, in a proportion sufficient to produce a degree of substitution ("DS") of 2.0 - 3.0 and a molar substitution ("MS") of between 2.0 - 5.0, preferably 2.0 - 3.0, and most preferably 3.0. (DS is the average number of substituted hydroxyl groups on each anhydroglucose monomeric unit of the cellulose chain. MS is the average number of moles of derivatized alkylene oxide per anhydroglucose monomeric unit.) The reaction conditions for the derivatization are well-known to those of ordinary skill in the art. It should be noted that the MS value may be higher than the DS value. This is because the first etherification reaction produces secondary hydroxyls which are available for further reaction with the oxide, and chaining out may take place. An example is the idealized structure shown by the following formula: 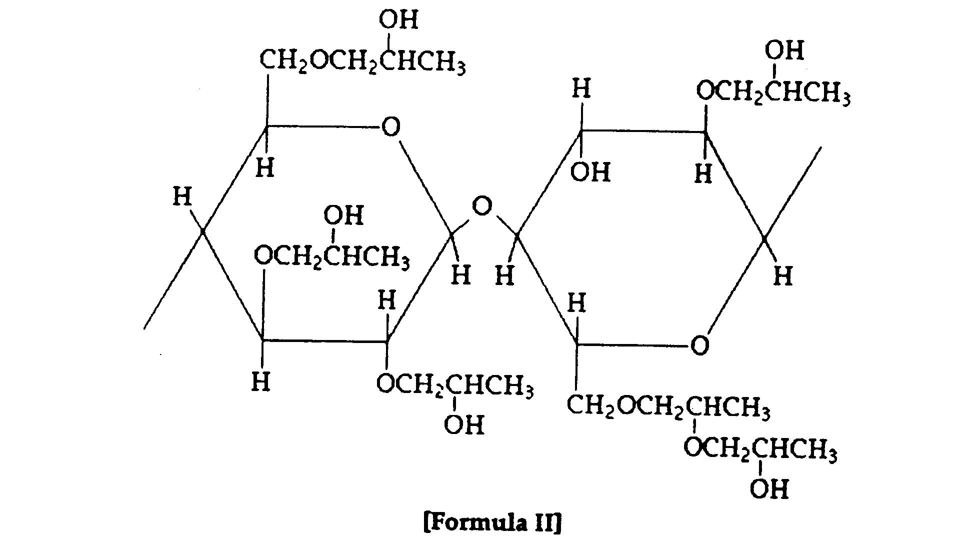
The idealized compound shown in Formula II is the reaction product of cellulose and propylene oxide, in a proportion sufficient to produce a DS of 2.0 - 3.0 and an MS of 3.0.

The molecular weight of these preferred binders is generally in the range of from about 50,000-900,000. The only restrictions on the molecular weight are that the higher the molecular weight of the binder, the more difficult it becomes to solubilize the binder for coating onto a cover sheet without the solution becoming too viscous and thus unworkable. A more preferred molecular weight range is from about 50,000 to 100,000. One binder which is particularly preferred is KLUCEL L (Aqualon, Inc.), a hydroxypropyl cellulose having an average molecular weight of about 75,000 and the idealized structure shown above in Formula II.

The most preferred slip film system for use in the invention comprises a hydroxypropyl cellulose having an average molecular weight of about 75,000 and the idealized structure shown above in Formula II, and a non-migrating surfactant having the generic formula R₁-B-OA₁O(A₂O)ᵣH, wherein R₁ is an octyl or nonyl group, A₁ and A₂ are methylene groups, B is phenylene substituted at the 1 and 4 positions with the R₁ and oxymethylene groups, respectively, and r is in the range of from about 90 to 150.

The slip film is typically prepared by making a homogeneous coating solution of polymeric binder and non-migrating surfactant in the desired ratio in an aqueous-based solvent. The coating solution is evenly applied to a cover sheet and dried. Any type of coating apparatus, e.g., curtain coating, extrusion coating, offset, two roll knife over roll, or gravure types, may be used. The cover sheet may be a polyethylene terphthalate film such as MELINEX 377 (ICI Americas), MYLAR (E.I. du Pont de Nemours & Co.), or other flexible polymeric films well-known to those skilled in the art. In a preferred embodiment the cover sheet is about 5mils thick, and the slip film layer is from about 0.05 to about 5mils thick.

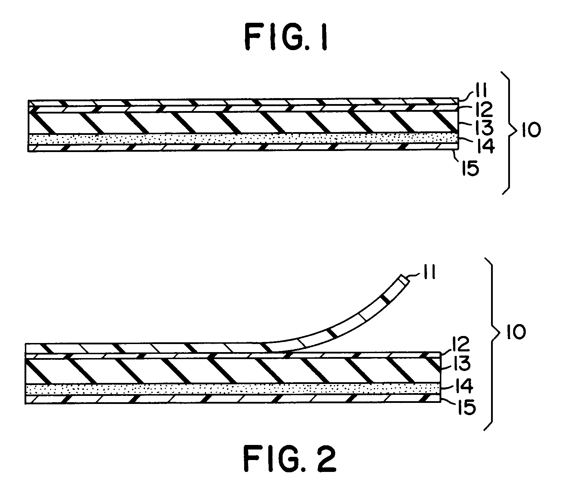

After the coating solution has dried, the slip film-coated surface of the cover sheet may be laminated to a layer of uncured flexible photocurable composition to form a photocurable element. Referring to the drawings, FIG. 1 depicts in cross-section a photocurable element **10** which may be prepared in this way. Element **10** includes a cover sheet **11**, a slip film **12,** photocurable layer **13,** adhesive layer **14,** and a support sheet **15****.** Element **10** may also be prepared by a method in which the uncured flexible photocurable composition is extruded directly onto the slip film-coated cover sheet, and a support sheet is heat-laminated onto the back face of the photocurable composition to form the element. This method of production may be coupled with an automated trimming apparatus to enable fast and efficient production of printing elements.

Aqueous photocurable compositions are known in the art. Classes of photocurable compositions that may be used are those containing nitrile rubbers and carboxylated nitrile rubbers which may be developed in aqueous alkaline solutions containing small amounts of water miscible solvents like butyl cellosolve or butyl carbitol, such as those described in U. S. Patent Nos. 4,517,279, issued May 14, 1985, and 4,689,290, issued August 25, 1987.

The '279 patent discloses a high molecular weight butadiene/acrylonitrile copolymer used in a photosensitive composition containing the following:
(A) 40 to 90% by weight of the total composition of a high molecular weight butadiene/acrylonitrile carboxylated copolymer having a number average molecular weight of 30,000 to 125,000, an acrylonitrile content of 10 to 50%, and a carboxyl content of 1% to 15% by weight;
(B) 5 to 60% by weight of the total composition of a high molecular weight butadiene/acrylonitrile noncarboxylated copolymer having a number average molecular weight of 50,000 to 100,000 and an acrylonitrile content of 10 to 30% so that the combination of the carboxylated and non-carboxylated high molecular weight copolymers give a composition with a carboxyl content of 3 to 10%;
(C) 2 to 40% by weight of the total composition of an addition photopolymerizable ethylenically unsaturated monomer; and
(D) 0.1 to 10% by weight of the total composition of photoinitiator activatable by actinic radiation.

The '290 patent discloses a flexible photopolymer printing plate composition comprising a homogenous blend of:
(A) a high molecular weight butadiene-acrylonitrile copolymer having a number average molecular weight of about 30,000 to 125,000, an acrylonitrile content of 10 to 50% by weight, a carboxyl content of 2 to 15% by weight, and a Mooney viscosity (ML-4 at 100°C) of 45 or higher; and
(B) a medium molecular weight butadiene-acrylonitrile copolymer having a number average molecular weight of about 15,000 to 40,000, an acrylonitrile content of 10 to 40% by weight, a carboxyl content of 1-15%, and a Mooney viscosity (ML-4 at 100°C) of from 15 to less than 45.

Another class of photocurable compositions are those based on maleated polybutadiene ionomers, such as those disclosed in European Patent Publication No. 456380A3. Yet another composition which may be used in the invention is that described in the aforementioned US Patent No. 5,077,175. The photocurable compositions generally also contain, in addition to the aforementioned polymeric binder or oligomer, one or more photopolymerizable monomers and one or more photoinitiators. Such monomers and photoinitiators, and their use in photocurable compositions, are well-known in the art. In any event, the type of flexible photocurable composition is not critical to the operation of the invention, provided that it has the requisite property of aqueous-processibility. Photocurable elements of the invention may be manufactured using any currently available method, such as that shown in the non-limiting examples below.

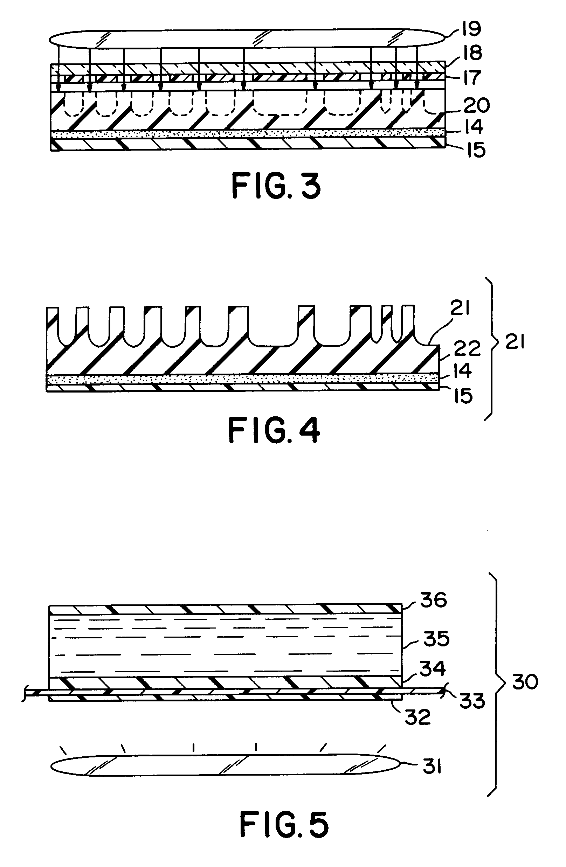

A flexographic printing plate may be prepared from the aqueous-processible photocurable element depicted in FIG. 1 as follows. Referring now to FIGS. 2, 3, and 4, which depicts this process, FIG. 2 shows cover sheet **11** in the process of being stripped off printing element **10**, leaving slip film **12** on the surface of photocurable layer **13**. In FIG. 3 an image-bearing transparency **17** has been laid onto the slip film **12** and a glass plate **18** has been laid on top of image-bearing transparency **17** to force it into intimate contact with slip film **12**. A vacuum may be applied to ensure better contact between image-bearing transparency **17** to force it into contact with slip film **12** if necessary. Actinic radiation source **19** is disposed over glass plate **18**, directing actinic radiation through the transparent regions of image-bearing transparency **17**, curing photocurable layer **13** to form latent relief image **20**. Thereafter glass plate **18** and image-bearing transparency **17** are removed from slip film **12**. The printing element is then washed with an aqueous or aqueous-based solvent system and a brushing action, which solvates and removes slip film **12** and the photocurable composition of layer **13** to produce printing plate **21**, having a developed relief image **22**, as shown in FIG. 4.

Yet another use of the slip film of the invention is in preparing relief images using liquid photopolymer systems. Typically in such systems, the image-bearing film must be separated from the liquid photopolymer by a 1 to 3mil thick layer of polyethylene, and as such, the quality of relief images obtained from such systems is not as good as could be obtained by doser proximity of the negative to the photopolymer, as is found in solid photopolymer systems. The problem cannot be avoided by using a thinner sheet of polyethylene because the thinner sheets stick to the cured photopolymer and ruin the latent relief image when the sheet is removed. However, a very thin, i.e., about 0.5mil, polyester sheet coated with a slip film of the invention, will not stick to the hardened photopolymer after exposure, and provides for much better relief images. As illustrated in FIG. 5, which shows a liquid photopolymer system **30** in the process of being imaged, an actinic radiation source **31** is positioned beneath an apparatus containing an uncured liquid photopolymer system **30**. Polyester support **36** lays over liquid photopolymer layer **35**, which has been deposited onto slip film **34** which has in turn been coated onto a thin transparent polyester sheet **33**. Polyester sheet **33** sits on image-bearing transparency **32** and protects it from contact with liquid photopolymer **35**. When the exposed system is removed from the imaging apparatus, the polyester sheet **33** may be stripped from the cured photopolymer layer of the printing element without fear of damaging the latent relief image. Although it is possible that some areas of slip film **34** may stick to the hardened photopolymer, the polyester sheet may still be easily stripped and the slip film remaining on the photopolymer will be removed from the photopolymer during washing with the aqueous developers after the bulk of the liquid photopolymer has been removed with an air knife.

The use of aqueous or semi-aqueous solvents is very beneficial for businesses and the environment in contrast to organic-based solvents, e.g., halogenated hydrocarbon solvents, because no costly or dangerous hazardous waste disposal is needed to remove the solvent from the print shop after plates have been processed. Such aqueous or semi-aqueous solvents often contain additives which promote the removal of the slip film and the uncured photocurable composition. Examples of such additives are amino-containing surfactants, such as TRITON RW150 (Rohm & Haas, Inc.), which is an ethoxylated amine of the general formula R-NH(OCH₂CH₂)ₙOH, wherein R is H or a C₁ to C₅ alkyl group and n is a number from 2 to 15; TOMAH E14-2, E17-2, and E18-5 (Tomah Products), ethoxylated amines of the same general formula wherein n is 14, 17 and 18, respectively; PEGAMON T15, T5 and T2 (GAF Corporation); and ETHOX TAM15 (Ethox Chemical).

### EXAMPLE 1

A comparative test between slip films induding and omitting the non-migrating surfactant was done to show the superiority of the inventive slip film composition. Aqueous-processible photocurable elements were made as follows. A slip film preparation of a 10% solution (by weight) of KLUCEL L (Aqualon, Inc) in a mixture of 1:1 H₂O:isopropanol (v/v) was prepared, and a portion of this preparation was evenly coated onto sheets of 5mil thick MELINEX 377 and dried to give a 0.07mil thick film; these were designated "slip film NA". To the remaining preparation was added a solution of 70% (by weight) T-DET 100 surfactant in water (to provide a concentration of 0.25% (by weight) of T-DET 100 based on the total final weight of the solution); the weight ratio of Klucel L to T-DET 100 in the slip film preparation was thus 40:1. This preparation was coated onto sheets of MELINEX 377 in the same manner and were designated "slip film A".

Printing element sub-structures comprising a photocurable layer were made by coating of maleated polybutadiene ionomer (35% by weight, in a solvent of 3:1 toluene:methylethylketone) onto a support sheet of polyethylene terphthalate using a continuous loop coater. The sub-structures were dried at 105°- 150°F for two days. Thereafter, the respective cover sheets coated with slip films A and NA were each laminated to the photopolymer layer of the individual sub-structures at ambient temperature using a standard two-roll laminator, and annealed for four hours at 125°F prior to trimming. The cover sheet was removed from a printing element of each type just after trimming. The cover sheet of the printing element with slip film A (containing the non-migrating surfactant) was slightly easier to remove in comparison to the printing element with slip film **NA**.

The photocurable elements with both types of slip films were subjected to aging tests to demonstrate the efficacy of the non-migrating surfactant of the invention. To reproduce typical storage conditions, a printing element of each type was aged at room temperature for one month. When the cover sheet was stripped from each printing element, about 20-25% of slip film NA was removed from the photocurable layer of the printing element. This left the exposed surface of the element unusable. On the other hand, all of slip film A remained on the photocurable layer of the printing element.

A printing element of each type underwent "accelerated aging" at 60°C for four hours. The cover sheet was thereafter stripped from each printing element; all of slip film NA was removed from the photocurable layer of the printing element, while substantially all of slip film A remained on the photocurable layer of the printing element.

### EXAMPLE 2

A test was done to contrast the performance of a slip film containing a migrating surfactant with that of the inventive slip film. Five slip film preparations of a 10% solution (by weight) of KLUCEL L (Aqualon, Inc.) in a mixture of 1:1 H₂O:isopropanol (v/v), were prepared, as in Exarnple 1. TRITON X-100 liquid surfactant (Rohm & Haas, Inc.) (having the formula R-C₆H₄-OCH₂CH₂O(CH₂CH₂O)ₓH, wherein R is octyl and x is 9 to 10), was added to each of these slip film preparations in amounts of 0.0625%, 1.25%, 2.5%, 5.0% and 10.0% (based on the final weight of the solution); the slip film preparations were thereafter designated Types T-1, T-2, T-3, T-4 and T-5, respectively. Each of these slip film compositions was then coated onto individual cover sheets and laminated to printing element sub-structures to form photocurable elements as in Example 1. During trimming of the photocurable elements with slip film T-5 (containing 10.0% TRITON X-100), the cover sheet delaminated from the photocurable element sub-structure, taking the slip film with it.

The cover sheet was removed from individual photocurable elements having slip film types T-1, T-2, T-3, and T-4, just after trimming. The slip film stuck to the surface of the photocurable layer and was not removed with the cover sheet. A photocurable element of each type was thereafter subjected to the accelerated aging test described in Example 1. When the cover sheet was removed from each photocurable element, the slip film stuck to the surface of the cover sheet, exposing the unacceptable tacky surface of the photocurable layer.

### EXAMPLE 3

A flexographic photocurable element with a slip film containing the non-migrating surfactant of the invention as made in Example 1, was imaged in a UV light exposure unit and developed in the following fashion. The element was initially given an overall back exposure through the support sheet to actinic radiation having an intensity of 23mJ/cm² for 15 seconds. This procedure cured the bottommost region of the printing plate to provide a "floor" for the relief image. Next, the element was turned over and the cover sheet was removed, leaving the slip film intact as a protective layer on the photocurable layer. An image-bearing transparency was laid over the photocurable layer, i.e., onto the slip film, and a transparent cover was laid onto the image-bearing transparency. To make sure the film completely contacted the slip film, a vacuum was applied.

The element was exposed to actinic radiation through the image-bearing transparency for a time sufficient to cure the photocurable material and form a latent relief image. After exposure the element was removed from the exposure unit and was placed in a washout unit which used a rotating cylinder with brushes, where the plate was washed for 20 minutes with a water solution containing 4% by weight of an ethoxylated amine (TRITON RW150) at a solution temperature of 150°F. The element was removed from the washout unit and was then post-treated by blotting dry, drying in an oven for one hour at about 150°F, and placing the element into a de-tack unit for exposure to actinic radiation, for about 10 minutes. This method produced a flexographic printing plate with a high quality relief image.

Thus it can be seen that aqueous or semi-aqueous-processible photocurable elements made and imaged in accordance with the invention, as above, show distinct advantages over the current art. It should be noted that the above example and description of embodiments of the invention are intended to illustrate the invention and are not meant as a limitation on it. It is intended that modifications and variations to the invention may be made within the scope of the appended claims.

## Claims

1. A composition comprising an aqueous-processible polymeric binder and a non-migrating surfactant.

2. A composition according to claim 1 wherein the non-migrating surfactant has a hydrophilic-lipophilic balance of from 16 to 19.

3. A composition according to claim 1 or 2 wherein the non-migrating surfactant is solid at a temperature below about 60°C.

4. A composition according to claim 3 wherein the non-migrating surfactant is solid at a temperature below about 30°C.

5. A composition according to any one of claims 1 to 4 wherein the non-migrating surfactant is an alkylphenol-polyethoxylated alcohol of the formula R₁-B-OA₁O(A₂O)ᵣH, wherein R₁ is a linear or branched alkyl group containing from 6 to 18 carbon atoms, B is a C₆ to C₁₀ arylene group, A₁ and A₂ are each individually a C₁ to C₅ alkylene group, and r is of a magnitude sufficient to make the surfactant solid at room temperature.

6. A composition according to claim 5 wherein r is greater than about 70.

7. A composition according to claim 6 wherein r is greater than about 90.

8. A composition according to any one of claims 5 to 7 wherein R₁ is a nonyl or octyl group and B is phenylene.

9. A composition according to any one of claims 5 to 9 wherein R₁ is an octyl or nonyl group, A₁ and A₂ are methylene groups, B is phenylene substituted at the 1 and 4 positions with said R₁ and said oxymethylene groups, respectively, and r is in the range of from 90 to 150.

10. A composition according to any one of claims 1 to 9 wherein the weight ratio of the non-migrating surfactant and the polymeric binder is from 1:35 to 1:66.

11. A composition according to claim 10 wherein the weight ratio of the non-migrating surfactant and the polymeric binder is from 1:40 to 1:60.

12. A composition according to any one of claims 1 to 11 wherein the polymeric binder is a carboxyalkylcellulose, a hydroxyalkylcellulose, an alkylcellulose, a polyvinylalcohol, a polyacrylic acid, a polyethylene oxide, a polyvinylmethyl ether, or a composition comprising at least 60% of a substantially hydrolyzed polyvinyl alcohol and at least 8% plasticizer, based on the total weight of the composition, or a mixture thereof.

13. A composition according to any one of claims 1 to 12 wherein the polymeric binder is a hydroxyalkylcellulose having repeating units of the general formula 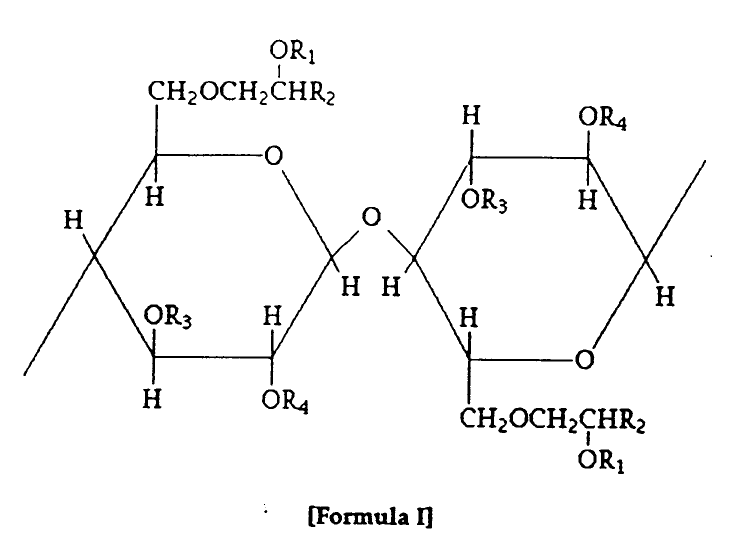 wherein
R₁ is H or 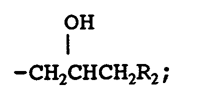 R₂ is H or C₁ to C₃ alkyl group; and
R₃ and R₄ are each independently H or

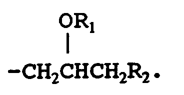

14. A composition according to claim 13 wherein the polymeric binder has a degree of substitution between 2.0-3.0 and a molar substitution between 2.0-5.0.

15. A composition according to claim 13 or 14 wherein the polymeric binder has a molecular weight in the range of from 50,000 to 900,000.

16. A composition according to claim 15 wherein the polymeric binder has a molecular weight in the range of from 50,000 to 100,000.

17. A composition according to any one of claims 1 to 16 wherein the polymeric binder is a hydroxyalkylcellulose having repeating units of the general formula

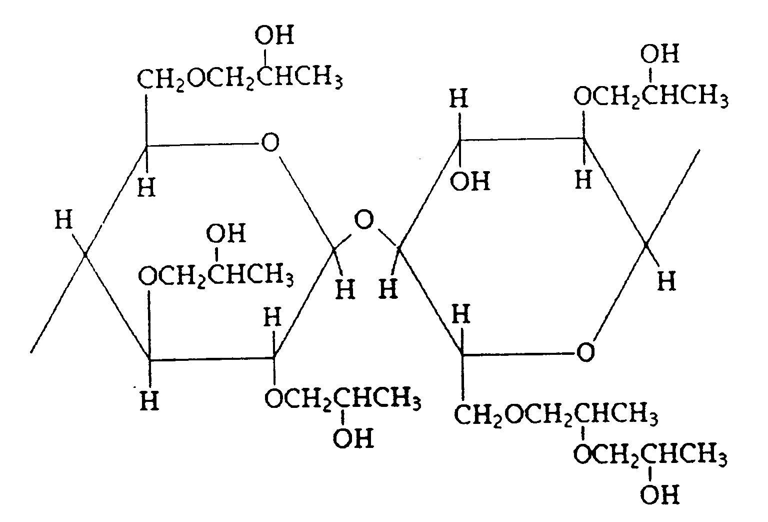

18. An aqueous-processible photocurable element comprising, in order:
(a) a support sheet;
(b) at least one layer of an aqueous-processible photocurable composition;
(c) a layer of an aqueous-processible slip film; and
(d) a flexible cover sheet,
wherein the slip film comprises a composition as defined in any one of claims 1 to 17, wherein the non-migrating surfactant is present in an amount which provides preferential adherence of the slip film to the photocurable composition, relative to the cover sheet.

19. A process for making a printing relief from a photocurable element, comprising the steps of:
(I) imagewise exposing to actinic radiation an aqueous-processible element according to claim 18; and
(II) removing the slip film and the unexposed portions of the photocurable composition by washing with an aqueous or substantially aqueous-based solvent.

20. A process according to claim 19 wherein the aqueous or substantially aqueous-based solvent comprises water and an amino-containing surfactant of the general formula R-NH(OCH₂CH₂)ₙOH, wherein R is H or a C₁ to C₅ alkyl group and n is a number from 2 to 18.
